# EUROPÄISCHE PATENTSCHRIFT

(11) **EP 0 632 277 B1**
(45) Veröffentlichungstag und Bekanntmachung des Hinweises auf die Patenterteilung: **03.03.1999**
(21) Anmeldenummer: 94106717.5
(22) Anmeldetag: 29.04.1994
(51) Int. Cl.: G01R 15/06, G01R 19/155, G01R 35/00

(54) **Prüfgerät**
Testing device
Appareil pour test

(30) Priorität: 15.07.1993 DE 4323731; 02.06.1993 DE 4318289
(43) Veröffentlichungstag der Anmeldung: 04.01.1995
(73) Patentinhaber: AEG Sachsenwerk GmbH, D-93055 Regensburg (DE)
(72) Erfinder: Schels, Wilhelm, Dipl.-Ing., D-93164 Laaber (DE); Karstens, Michael, D-94315 Straubing (DE)
(74) Vertreter: Dreiss, Fuhlendorf, Steimle & Becker

(56) Entgegenhaltungen:
- EP-A- 0 344 479
- DE-A- 3 219 703
- DE-A- 3 712 783
- DE-A- 4 133 936
- US-A- 4 814 933
- US-A- 5 077 520
- ELEKTROTECHNISCHE ZEITSCHRIFT - ETZ, Bd. 112, Nr. 1, Januar 1991 BERLIN DE, Seiten 24-27, G.BRÜGGEMANN ET AL. 'Kapazitive Spannungsanzeigesysteme'

## Beschreibung

Die Erfindung betrifft ein Prüfgerät gemäß dem Oberbegriff des ersten Anspruchs.

Ein bekanntes Prüfgerät dieser Art (Entwurf DIN VDE 0681 Teil 7, Seite 35) ist zur Anzeige des Vorhandenseins der elektrischen Spannung in Hoch- oder Mittelspannungsanlagen vorgesehen. Dabei ist ein Koppelteil mit einer elektrischen Koppelelektrode ausgestattet, die kapazitiv an ein zu überwachendes, ggf. hochspannungsführendes elektrisches Bauteil angekoppelt ist. Von dieser Elektrode führt eine Leitung zu einer spannungsbegrenzenden Sollbruchstelle z. B. in Form einer Funkenüberschlagsstrecke, die gegen Masse geschaltet ist. Parallel zu dieser Sollbruchstelle liegt ein elektrischer Kondensator als Messbeschaltung zur Begrenzung der Ausgangsspannung, die an eine am Koppelteil frei von außen zugängliche Steckbuchse angelegt ist. Eine weitere, gegen Masse geschaltete Steckbuchse bildet eine Steckbuchsenanordnung für den Anschluß einer Anzeigeeinrichtung, mit welcher das Vorhandensein oder Fehlen der elektrischen Hochspannung signalisiert wird. Die Anordnung ist dabei so getroffen, daß bei funktionsgerechtem Aufbau des Koppelteils die Anzeigeeinrichtung ein Betriebsstrom-Anzeigesignal auf optischer Basis erzeugt, wenn bei am hochspannungsaktiven Teil anliegender Hochspannung und einer bestimmten Eingangsimpedanz der Anzeigeeinrichtung z. B. von 2 Megaohm das Koppelteil einen vorbestimmten Betriebsstrom-Wert, vorliegend 2,5 Mikroampere, durch die Eingangsimpedanz der Anzeigeeinrichtung fließen läßt. Dabei ist bei anliegender Nennspannung am hochspannungsführenden Bauteil vorgesehen, daß aus Sicherheitsgründen der Schaltungsaufbau des Koppelteils so bemessen ist, daß bei vorgeschriebener Funktion ein um einen bestimmten Mindest-Differenzwert, vorliegend 1,1 Mikroampere, erhöhter Strom durch die Eingangsimpedanz der Anzeigeeinrichtung fließt, also der Koppelteil wenigstens 3,6 Mikroampere als Prüfstromwert liefert. Bei Alterung und betriebsbedingten Veränderungen der Bauteile im Koppelteil ist dann sichergestellt, daß bei anliegender Hochspannung am hochspannungsführenden Bauteil tatsächlich eine Anzeige des Betriebszustandes erfolgt. Von Nachteil ist dabei jedoch, daß beim Anschalten der Anzeigeeinrichtung nicht geprüft wird, ob der Koppelteil seine geforderte Funktion also auch mit der erforderlichen Zuverlässigkeit erfüllt. Eine Überprüfung ist nur mit Hilfe eines zusätzlichen Testgerätes möglich.

Aus der DE 41 33 936 A1 ist eine Anzeigeeinrichtung für elektrische Wechselspannungen bekannt, die zwei Koppelkondensatoren an einem spannungsaktiven Bauelement aufweist, welche Steuersignale an unterschiedliche Eingänge einer Signalverarbeitungsschaltung abgeben. Die Signalverarbeitungsschaltung enthält eine Schaltlogik, die beim Vorhandensein von annähernd gleich hohen Signalen an den Eingängen ein Anzeigeelement zur Anzeige von Hochspannung aktiviert und bei Fehlen der beiden Eingangssignale ein Anzeigeelement für die Anzeige der fehlenden Hochspannung am Bauelement aktiviert. Ist dagegen nur ein Signal an einem der Eingänge vorhanden, wird die Signalanzeige insgesamt deaktiviert. Auf diese Weise wird bei der DE 41 33 936 A1 eine Eigenkontrolle insoweit erreicht, als ein Ausfall oder dergleichen eines der beiden Koppelkondensatoren erkannt werden kann. Eine etwa gleichartige Alterung der beiden Koppelkondensatoren und die damit verbundene, nicht mehr ordnungsgemäße Funktion derselben wird jedoch nicht erkannt.

Der Erfindung liegt die Aufgabe zugrunde, bei einem Prüfgerät gemäß dem Oberbegriff des ersten Anspruchs Maßnahmen zu treffen, durch welche bei der Messung des vorbestimmten Betriebsstrom-Wertes eine Überprüfung des Koppelteils auf ordnungsgemäße Funktion erreicht wird.

Die Lösung dieser Aufgabe erfolgt gemäß der Erfindung durch die kennzeichnenden Merkmale des ersten Anspruchs.

Bei einem Aufbau eines Prüfgeräts gemäß der Erfindung wird nicht nur das Betriebsstrom-Anzeigesignal sondern gleichzeitig auch ein Mindestprüfstromwert überwacht, der um einen vorbestimmten Differenzwert über dem vorbestimmten Betriebsstrom-Wert liegt. Dazu wird an die Eingangsimpedanz der Anzeigeeinrichtung ein zusätzlicher Meßpfad angeschaltet, der ein eigenes Prüfstrom-Anzeigesignal erzeugt, das ebenfalls in ein optisches oder akustisches

Signal umgewandelt werden kann. Durch diese Maßnahmen ist sichergestellt, daß bei einer Veränderung der elektrischen Impedanzen des Koppelteils ein Warnsignal generiert werden kann, wenn zwar das Betriebsstrom-Anzeigesignal, aber nicht mehr das Prüfstrom-Anzeigesignal erzeugt wird. Wenn demnach beide Anzeigesignale vorhanden sind, ist sowohl die Nennspannung am hochspannungsaktiven Teil vorhanden als auch das Koppelteil funktionstüchtig im Sinne der erforderlichen Zuverlässigkeitsmaßstäbe. Fehlt nur das Betriebsstrom-Anzeigesignal, dann kann auf einen Fehler in der Anzeigeeinrichtung geschlossen werden, während beim Fehlen nur des Prüfstrom-Anzeigesignals ein Defekt im Koppelteil gegeben ist. Durch diese zweistufige Anzeige ist sichergestellt, daß Fehler in der Meßbeschaltung ermittelt werden. Diese Meßbeschaltung kann als Dauermeßeinrichtung in eine Schaltfeldfront integriert werden, wobei sich hier insbesondere die Nutzung des Koppelteils anbietet. Dabei kann dieses Dauerspannungsanzeigesystem auch in dreiphasigen Netzen angewandt werden. Fremdenergie ist hierbei nicht erforderlich. Die beiden Anzeigesignale können dabei auch derart je Phase elektrisch verknüpft werden, daß bei vorhandenem Betriebsstrom-Anzeigesignal und fehlendem Prüfstrom-Anzeigesignal ein Warnsignal generiert wird. Bei dauernder Anschaltung der Anzeigeeinrichtung kann zudem die vorgeschriebene Wiederholungsprüfung durch einfache Sichtkontrolle der Anzeigeelemente bei vorhandener Betriebsspannung erfolgen. Dabei müssen beide Überwachungsstufen anzeigen, so daß kein Warnhinweis erscheint. Eine besondere Prüfung ist noch möglich, wenn parallel an den einzigen Strommeßeingang der Anzeigeeinrichtung eine Prüfimpedanz schaltbar ist, die für die Ableitung eines dem Differenzwert der zu überwachenden Ströme entsprechenden Stromes bemessen ist. Bei der Anschaltung dieser Prüfimpedanz darf dann nur das Prüfstrom-Anzeigesignal ausfallen, nicht jedoch das Betriebsstrom-Anzeigesignal. Für das Einschalten dieser Prüfimpedanz ist zweckmäßig, zum Eingang der Anzeigeeinrichtung eine Steckbuchsenanordnung parallelzuschalten, die frei von außen zugänglich am Koppelteil montiert ist und für das vorübergehende Anstecken der Prüfimpedanz geeignet ist. Eine besonders einfache und ohne Fremdenergie arbeitende Anzeigeeinrichtung läßt sich dadurch erstellen, daß ein Teil der über die Koppelelektrode gewonnenen elektrischen Energie gleichgerichtet und einer Zenerdiode zugeführt wird, die als Stromquelle für nachgeschaltete Steuerelemente dient. Dabei handelt es sich insbesondere um die Stromversorgung für die Spannungspegel-Erkennungsschaltungen mit den nachgeschalteten Anzeigeelement-Ansteuerungen und den Anzeigeelementen. Eine Anzeige mit besonders niedrigem Energie bedarf läßt sich durch Anwendung einer LCD-Anzeigeeinheit realisieren. Dabei ist nur ein einziges LCD-Feld erforderlich, das in einem Grundfeld ein einen Pfeil darstellendes Pfeilfeld und daneben ein ein Dreieck darstellendes Dreieckfeld mit davon umschlossenem, ein Ausrufezeichen darstellendem Ausrufezeichenfeld aufweist. Dabei braucht das Pfeilfeld nicht ansteuerbar zu sein, erfordert also auch keinen Energieaufwand. Das Grundfeld ist dagegen elektrisch mit dem Ausrufezeichenfeld gekoppelt, so daß bei Vorhandensein des vom Betriebsstrom-Anzeigesignal abhängigen Ansteuersignals diese beiden Felder eine gegenüber dem hellen Ausgangszustand, den das Pfeilfeld immer aufweist, dunkleren Anzeigezustand einnehmen. Bei fehlendem, vom Prüfstrom-Anzeigesignal abhängigem Ansteuersignal für das Dreieckfeld bleibt dieses im hellen Ausgangszustand, so daß in diesem Betriebsfall angezeigt wird, daß zwar das zu überwachende Hochspannungssignal vorhanden, der von der Koppelschaltung jedoch zu liefernde Prüfstrom nicht in ausreichender Höhe vorhanden ist. Ist dieser Prüfstrom jedoch zumindest in seiner Mindeststromstärke gegeben, das Koppelteil also funktionstüchtig, dann wird auch das Dreieckfeld angesteuert und erscheint dann einheitlich wie das Grundfeld und das Ausrufezeichenfeld. Es erscheint daher nur das Pfeilfeld. Fehlt dagegen nur das dem Betriebsstrom-Anzeigesignal entsprechende Ansteuersignal, dann bleibt das Grundfeld wie das Pfeilfeld und das Ausrufezeichenfeld im hellen Betriebszustand und nur das Dreieckfeld wird farblich umgesteuert. Das Dreieckfeld erscheint dadurch dunkel und als Warnhinweis mit hellem Ausrufezeichenfeld. Diese Ausgestaltung des Anzeigeelements erübrigt es, logische Schaltungselemente zu verwenden, die sonst als zusätzliche Stromverbraucher in Erscheinung treten.

Es ist auch möglich, ein kombiniertes Anzeigeelement als LCD-Element mit einem in der Fläche vorgesehenen Pfeilfeld und einem in dem Pfeilfeld vorgesehenen Warnfeld auszubilden. Solange hierbei der Mindestprüfstromwert von der Koppelschaltung geliefert wird, werden im nicht angesteuerten Grundfeld sowohl das Pfeilfeld wie das Warnfeld angesteuert, so daß das Warnfeld nicht im Pfeilfeld in Erscheinung tritt und das Pfeilfeld die ordnungsgemäße Funktion der Gesamteinrichtung signalisiert. Sinkt dagegen der vom Koppelteil gelieferte Strom unter den Mindestprüfstromwert ab, schaltet die Spannungspegel-Erkennungsschaltung mit der nachgeschalteten LCD-Ansteuerschaltung die Spannung vom Warnfeld ab, so daß dasselbe wie das Grundfeld in Erscheinung tritt. Das Warnfeld hebt sich somit vom andersfarbigen Pfeilfeld 27 ab, so daß bei der Anzeige der vorhandenen Hochspannung der Warnhinweis auf eine nachlassende Funktionstüchtigkeit des Koppelelements gegeben wird.

Die Erfindung ist nachfolgend anhand der Prinzipskizzen von Ausführungsbeispielen näher erläutert.

Es zeigen:
Fig. 1 ein mit einer integrierten Anzeigeeinrichtung ergänztes Prüfgerät mit vorschriftsmäßigem Koppelteil,
Fig. 2 ein Balkendiagram über Stromwerte des Koppelteils und des Anzeigeelements und
Fig. 3 eine Prinzipschaltung einer Anzeigeeinrichtung.
Fig. 4 ein abgewandeltes kombiniertes Anzeigeelement.

In einer nicht dargestellten Hochspanungsanlage, insbesondere einer Mittelspannungsschaltanlage, die vorzugsweise ein ggf. gasdicht geschlossenes Schaltschrankgehäuse aufweist, befindet sich ein mit Hochspannung beaufschlagtes elektrisches Bauteil 1 vorzugsweise im Bereich der Kabelanschlüsse, an das eine elektrisch isolierte Koppelelektrode 2 kapazitiv angekoppelt ist. Die Koppelelektrode 2 ist über die Parallelschaltung einer spannungsbegrenzenden Solldurchbruchsstelle 3 (Funkenüberschlagstrecke) und einer Meßbeschaltung 4 an Geräte-Masse als Bezugspotential angeschlossen. Dabei wird davon ausgegangen, daß diese Meßbeschaltung und Solldurchbruchsstelle elektrisch parallel liegende Streukapazitäten 5 aufweisen. Von der Koppelelektrode 2 führt eine Verbindungsleitung 6 einerseits zu einer autarken Anzeigeeinrichtung 7, die ebenfalls als Bezugspotential Masse verwendet, sowie zu einem Prüfanschluß 8. Dem Prüfanschluß 8 ist dabei ein an Masse angeschalteter Zusatzanschluß zugeordnet. Die Meßbeschaltung 4, die eine aus einem Kondensator gebildete Impedanz darstellt, bildet eine Impedanz eines Spannungsteilers, an dem eine über die Koppelelektrode 2 eingekoppelte Spannung für die Anzeigeeinrichtung abgenommen wird. Die Meßbeschaltung 4 ist zusammen mit der Anzeigeeinrichtung 7 und den Anschlüssen 8, 9 als integrierbares Einbaugerät 10 ausgebildet, das dem auch die Koppelelektrode 2 und die Solldurchbruchsstelle 3 umfassenden Koppelteil 11 zugeordnet ist. Die Anschlüsse 8, 9 sind dabei von außen frei zugänglich und dienen zum manuellen Anschluß des Phasenvergleichsprüfgerätes, können aber auch dem Anschluß einer weiteren von außen anschließbaren Einrichtung zur Überprüfung der erforderlichen Anzeigezuverlässigkeit dienen.

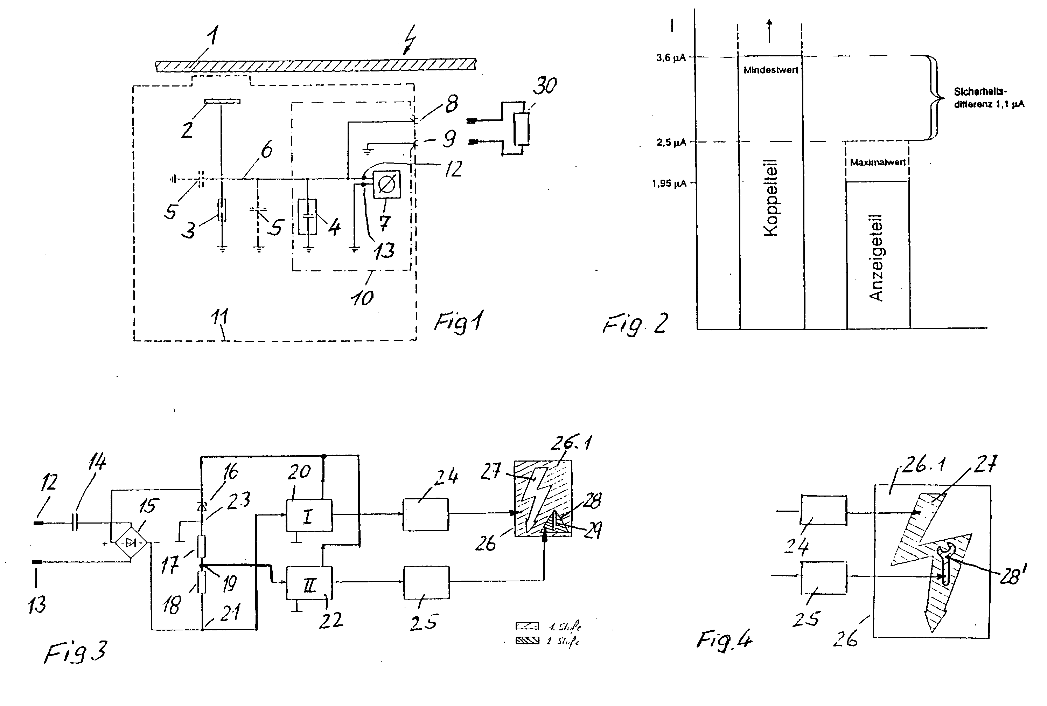

Die Anordnung nach Fig. 1 ist hinsichtlich der elektrischen Schaltungsmittel so ausgelegt, daß das Koppelteil bei an Hochspannung liegendem Bauteil 1 bei vorschriftsmäßiger Funktion einen Mindeststrom von 3,6 Mikroampere durch eine angeschlossene Impedanz von 2 Megaohm fließen läßt. Diese Eingangsimpedanz bzw. diesen Eingangswiderstand weist die Anzeigeeinrichtung 7 auf. Wie weiter in Fig. 2 dargestellt, muß die Anzeigeeinrichtung 7 bei einem Wert von 1,95 Mikroampere bis 2,5 Mikroampere ein Anzeigesignal generieren. Die von der Anzeigeeinrichtung gesteuerten Anzeigeelemente können dabei gemäß den Vorschriften selbstleuchtende Elemente, wie Glüh- oder Glimmlampen, LED oder nicht selbstleuchtende Anzeigeelemente wie LCD-Anzeigen oder akkustische Signalgeber sein. Die weitere Vorschrift besteht im übrigen darin, daß zwischen dem von dem Koppelteil gelieferten Mindeststrom zum vorbestimmten Wert des Eingangsstromes der Anzeigeeinrichtung, bei dem Anzeigeelemente aktiviert sein müssen, eine Sicherheitsdifferenz von 1,1 Mikroampere beträgt. Der vom Koppelteil zu liefernde Mindestwert ist nachfolgend als Mindestprüfwert und der vorbestimmte Wert, bei dem die Aktivierung eines Anzeigeelementes erfolgen muß, als vorbestimmter Betriebsstrom-Wert bezeichnet. Letzterer erzeugt ein Betriebsstrom-Anzeigesignal, während der erstgenannte ein Prüfstrom-Anzeigesignal erzeugt.

Der Schaltungsaufbau der Anzeigeeinrichtung 7 ist in Fig. 3 dargestellt. Der Eingangsanschluß 12, 13 der Anzeigeeinrichtung 7 ist einerseits an die Verbindungsleitung 6 andererseits an die Gerätemasse angeschlossen. Dabei liegt im Leitungszug des Eingangsanschlusses 12 ein elektrischer Trennkondensator 14, der an einen Wechselstromeingang eines Brückengleichrichters 15 gelegt ist, während der andere Eingangsanschluß 13 an dem Gerätemasseanschluß liegt. Vom positiven Ausgang des Brückengleichrichters 15 führt eine Leitung zu der Katode einer Zenerdiode 16, zu der in Serie die Reihenschaltung aus zwei Spannungsteilerwiderständen 17, 18 liegt, die an den negativen Ausgang des Gleichrichters 15 gelegt ist. Vom Kopfabgriff 21 des Spannungsteilers 17, 18 führt eine Leitung zum Eingang einer ersten Spannungspegel-Erkennungsschaltung 20 und vom Abgriff 19 des Spannungsteilers 17, 18 eine Leitung zum Eingang einer zweiten Spannungspegel-Erkennungsschaltung 22. Der Fußpunkt 23 und damit die Verbindungsstelle mit der Zenerdiode 16 ist an eine Schaltungsmasse gelegt, die nicht identisch mit der Gerätemasse des übrigen Koppelteils 11 ist. An diese Schaltungsmasse sind auch die Spannungspegel-Erkennungsschaltungen 20, 22 gelegt. Die Zenerdiode 16 liefert eine stabilisierte Versorgungsspannung für die beiden Spannungspegel-Erkennungsschaltungen 20, 22 und wird an den positiven Anschlüssen des Gleichrichters 15 bzw. der Zenerdiode 16 abgegriffen. Die Zenerdiode 16 liefert somit aus dem Eingangsstrom der Anzeigeeinrichtung 7 zugleich den Versorgungsstrom für die nachgeschalteten Spannungspegel-Erkennungsschaltungen 22, 20 und die denselben jeweils nachgeschalteten LCD-Ansteuerschaltungen 24, 25 und eines von denselben angesteuerten LCD-Anzeigeelements 26. Die Spannungspegel-Erkennungsschaltungen 20, 22 sind nach Art von Schwellwertschaltern oder Schmidt-Triggern aufgebaut und wirken so als Ein-Ausschalter. Ihre für eine Umschaltung erforderlichen Eingangssignale sind jeweils gleich groß, um gleiche Bauelemente verwenden zu können. Ihre auf die Eingangssignale bezogene unterschiedliche Ansprechschwelle wird durch den Spannungsteiler 17, 18 erzeugt. Bei ungleichen, auf die Funktion abgestimmten Ansprechwerten kann ggf. auf den Spannungsteiler 17, 18 verzichtet werden.

Das LCD-Anzeigefeld 26 vereinigt in sich mehrere Anzeigefelder. So ist in dem als rechteckige Fläche dargestellten Grundfeld 26.1 ein Pfeilfeld 27 und daneben mit Abstand ein Dreieckfeld 28 ausgebildet, in welchem ein Ausrufezeichenfeld 29 vorgesehen ist. Die gesamte Fläche des Anzeigeelements 26 ist im unangesteuerten Zustand farblich einheitlich, so daß einzelne Felder bzw. Anzeigeelemente nicht erkennbar sind. Dabei ist die Anordnung so getroffen, daß das Pfeilfeld 27 nicht ansteuerbar ist, also immer die Grundfarbe beibehält. Das Grundfeld 26.1 wird dagegen über die Ansteuerschaltung 24 zusammen mit dem Ausrufezeichenfeld 29 angesteuert und hebt sich dann farblich vom Pfeilfeld 27 ab. Das Dreieckfeld 28 wird dagegen von der Ansteuerschaltung 25 versorgt und wechselt ebenfalls von heller nach dunklerer Farbe.

Die Funktion der Anzeigeeinrichtung 7 gemäß Fig. 3 ist demnach so, daß bei vorhandener Hochspannung am Bauteil 1 und ordnungsgemäßer Funktion des Koppelteils 11 sowie der Anzeigeeinrichtung 7, also bei Einspeisung des Mindestprüfwertes des eingespeisten Stromes von wenigstens 3,6 Mikroampere über den Gleichrichter 15 nicht nur die Stromversorgung für die Bauelemente 20, 22 und 24 bis 29, sondern auch für den Spannungsteiler 17, 18 erzeugt wird. Bei diesem ordnungsgemäßen Betriebszustand reichen die am Spannungsteiler 17, 18 abgegriffenen Eingangsspannungen für die Spannungspegel-Erkennungsschaltungen 20, 22 aus, die nachgeschalteten Anzeigeelemente zu aktivieren. Es sind dann alle Felder bis auf das Pfeilfeld 27 der Anzeigeeinrichtung 26 einheitlich dunkel, so daß nur das Anzeigesignal "Hochspannung vorhanden" (Pfeilfeld 27 hell) in Erscheinung tritt. Der Spannungsteiler 17, 18 ist so ausgelegt, daß die Schaltstufen der Spannungspegel-Erkennungsschaltungen 20, 22 um den Differenzwert unterschiedlich sind, der sich aus der vorgegebenen Differenz zwischen Mindestprüfwert des eingespeisten Stromes in die Anzeigeeinrichtung 7 und dem Betriebsstrom-Wert ergibt, oberhalb dem ein Anzeigesignal als Hinweis auf vorhandene Hochspannung erscheinen muß. Sinkt also z. B. durch alterungsbedingte Änderungen der vom Koppelteil 11 gelieferte Strom unter den Mindestprüfstromwert von 3,6 Mikroampere aber nicht unter den Betriebsstromwert von 1,95 bis 2,5 Mikroampere, dann reicht die am Spannungsteilerabgriff 19 anstehende Steuerspannung für die Spannungspegel-Erkennungsschaltung 22 nicht mehr aus, dieselbe im Einschaltzustand zu halten. Dadurch wird über die nachgeschaltete LCD-Ansteuerschaltung 25 das Dreieckfeld 28 spannungslos, so daß dieses Feld in den hellen Ursprungszustand zurückgeht. Es bleibt dann das Grundfeld 26.1 mit dem Ausrufezeichenfeld 29 aktiviert und damit dunkel, wobei das Grundfeld 26.1 das Anzeigesignal "Hochspannung vorhanden" anzeigt und das dunkle Ausrufezeichenfeld 29 als Warnhinweis auf eine fehlerhafte Funktion in Erscheinung tritt. Diese Anzeigekonstellation tritt auch dann ein, wenn diese zweite Stufe II der Spannungspegel-Erkennung, also der Pfad zwischen dem Spannungsteilerabgriff 19 und dem Dreieckfeld 28 defekt ist. Wenn dagegen bei ordnungsgemäßer Funktion aller übrigen Bauteile, die erste Stufe I der Spannungspegel-Erkennung 20 zwischen dem Abgriff 21 und dem Grundfeld 26.1 ausfällt, bleibt das helle Ausrufezeichenfeld 29 im dunklen Dreieckfeld 28 erhalten. In diesem dunklen Dreieckfeld erscheint als Warnhinweis somit das helle Ausrufezeichenfeld 29. Auch bei einem Defekt im Spannungsteilerzweig 17, 18 wird so eine Eigenüberwachung der Anzeigeeinrichtung 7 erzielt. Dieser Vorteil wird durch den zweizügigen Aufbau der Steuerschaltungen für das Anzeigeelement 26 erreicht, also durch einen zusätzlichen Meßpfad, der bei einem um den vorbestimmten Differenzwert über dem vorbestimmten Betriebststrom-Wert liegenden Mindestprüfwert des eingespeisten Stromes ein zusätzliches Steuersignal generiert, das ein eigenes Prüfstrom-Anzeigesignal erzeugt. Dieses Prüfstrom-Anzeigesignal ist im Anzeigefeld 26 so abgebildet, daß das Dreieckfeld 28 als Warnfeld im angesteuerten Grundfeld 26.1 nicht in Erscheinung tritt, das unangesteuerte Pfeilfeld als Hinweis auf vorhandene Hochspannung jedoch erhalten bleibt. Aus dieser im Anzeigeelement 26 begründeten Verknüpfung des Betriebsstrom-Anzeigesignals mit dem Prüfstrom-Anzeigesignal erübrigen sich zusätzliche logische Schaltelemente und es wird bei vorhandenem Betriebsstrom-Anzeigesignal, also bei Einspeisung von mindestens 2,5 Mikroampere aber fehlendem Prüfstrom-Anzeigesignal, also Einspeisung von weniger als 3,6 Mikroampere das Warnsignal in Form des hellen Dreieckfeldes 28 mit dem darin enthaltenen dunklen senkrechten Ausrufezeichenfeld 29 generiert.

Um eine manuelle Wiederholungsprüfung ausführen zu können, sind die Prüfanschlüsse 8, 9 gemäß Fig. 1 vorgesehen. An diese Prüfanschlüsse wird im Bedarfsfall eine Impedanz 30 angeschaltet, die von der Verbindungsleitung 6 zur Gerätemasse einen Strom ableitet, der dem vorgeschriebenen Differenzwert zwischen Mindestprüfwert und vorbestimmten Betriebsstrom-Wert, also 1,1 Mikroampere entspricht. Durch die Anschaltung dieser Impedanz 30 kann der Eingangsmeßstrom den Mindestprüfstromwert unterschreiten, so daß das Dreieckfeld 28 spannungslos wird und damit in den hellen Ausgangszustand zurückkehrt. Prüfkriterium ist, daß auf keinen Fall Grundfeld 26.1, Ausrufezeichenfeld 29 und Dreieckfeld 28 spannungslos werden und damit in den hellen Ausgangszustand zurückkehren, also der tatsächlich vom Koppelteil gelieferte Strom den Mindestprüfstromwert von 3,6 Mikroampere nicht unterschreitet.

In einer Abwandlung des Anzeigeelements 26 gemäß Fig. 4 wird bei sonst gleichem Schaltungsaufbau der Anzeigeeinrichtung gemäß Fig. 3 ein scheibenförmiges LCD-Element verwendet, bei dem in einem nicht angesteuerten Grundfeld 26.1 ein Pfeilfeld 27 und in diesem Pfeilfeld 27 ein als Schraubenschlüssel dargestelltes Warnfeld 28' ausgebildet. Das Pfeilfeld 27 wird dabei über den ersten Meßpfad 20, 24 und das getrennt ansteuerbare Warnfeld 28' über den zweiten Meßpfad 22, 25 gesteuert. Bei einem über dem Mindestprüfstromwert von 3,6 Mikroampere liegenden Eingangsstrom werden über den Spannungsteiler 17, 18 sowohl der Meßpfad I mit der Spannungspegel-Erkennungsschaltung 20 und dem nachgeschalteten LCD-Ansteuerschaltungselement 24 das Pfeilfeld 27 und über den zweiten Meßpfad II mit der zugehörigen Spannungspegel-Erkennungsschaltung 22 und dem nachgeschalteten LCD-Ansteuerschaltungselement 25 das Warnfeld 28' mit einer Steuerspannung beaufschlagt. Die beiden Felder 27, 28' sind dadurch gleichfarbig und heben sich voneinander nicht ab, so daß insgesamt im farblich unterschiedlichen, im allgemeinen helleren Grundfeld 26.1 nur das Pfeilfeld 27 als Hinweis auf vorhandene Hochspannung am Bauteil 1 gegeben wird. Sinkt dagegen im Laufe der Betriebszeit durch irgendwelche Einflüsse, der vom Koppelteil 11 ingesamt gelieferte Eingangsstrom unter den Mindestprüfstromwert ab, dann sinkt auch die Spannung am Spannungsteilerabgriff 19 unter einen Wert der die Spannungspegel-Erkennungsschaltung 22 zurückschaltet, so daß das LCD-Ansteuerelement 25 die Steuerspannung vom Warnfeld 28' abschaltet. Dadurch hebt sich bei weiterhin angesteuertem Anzeigefeld 27 das dann farblich veränderte Warnfeld 28' vom Pfeilfeld 27 ab, so daß es als Warnhinweis in Erscheinung tritt. Bei der Überprüfung einer so ausgerüsteten Hochspannungseinrichtung wird somit jeweils ein Warnsignal erzeugt, das auf einen Mangel hinweist, ohne die Anzeige des Vorhandenseins der Hochspannung zu beeinflussen.

## Patentansprüche

1. Prüfgerät zur Anzeige des Vorhandenseins der elektrischen Nennspannung in Hoch- oder Mittelspannungsschaltanlagen oder -geräten mit einer kapazitiv an ein zu überwachendes spannungsaktives elektrisches Bauteil (1) angekoppelten Elektrode (2) eines Koppelteils (11), an das eine Anzeigeeinrichtung (7) angeschlossen ist, die bei Einspeisung eines vorbestimmten Wertes eines Betriebsstroms ein Betriebsstrom-Anzeigesignal erzeugt, **dadurch gekennzeichnet**, daß die Anzeigeeinrichtung (7) einen zusätzlichen Meßpfad (22, 25) aufweist, der bei einem um einen vorbestimmten Differenzwert über dem vorbestimmten Wert des Betriebsstroms liegenden Wert eines vom funktionstüchtigen Koppelteil (11) zu liefernden Mindestprüfstroms ein zusätzliches Steuersignal generiert, das ein eigenes Mindestprüfstrom-Anzeigesignal erzeugt.

2. Prüfgerät nach Anspruch 1, dadurch gekennzeichnet, daß das Betriebsstrom-Anzeigesignal und das Mindestprüfstrom-Anzeigesignal derart verknüpft sind, daß bei vorhandenem Betriebsstrom-Anzeigesignal und fehlendem Mindestprüfstrom-Anzeigesignal ein Warnsignal generiert wird.

3. Prüfgerät nach Anspruch 1 oder 2, dadurch gekennzeichnet, daß dem einzigen StrommeßEingang (12, 13) der Anzeigeeinrichtung (7) eine Prüfimpedanz (30) parallelschaltbar ist, die für die Ableitung des dem Strom-Differenzwert aufweisenden Stromes bemessen ist.

4. Prüfgerät nach einem der Ansprüche 1 bis 3, dadurch gekennzeichnet, daß mit dem Strommeßeingang (12, 13) des Anzeigegerätes (7) ein Abgriffe (19, 21) aufweisender Spannungsteiler (17, 18) verbunden ist, wobei an einen ersten Abgriff (21) eine Spannungspegel-Erkennungsschaltung (20) für das dem vorbestimmten Betriebssstrom-Wert entsprechende Anzeigesignal und an einen zweiten Abgriff (19) eine Spannungspegel-Erkennungsschaltung (22) für das von dem Mindestprüfstromwert abhängige Mindestprüfstrom-Anzeigesignal angeschaltet ist.

5. Prüfgerät nach Anspruch 4, dadurch gekennzeichnet, daß die Spannungspegel-Erkennungsschaltungen (20, 22) je eine Anzeige-Ansteuerung (24, 25) speisen, die bei vorhandenen Anzeigesignalen je ein oder zwei Anzeigeelemente (26.1, 28, 29) aktivieren.

6. Prüfgerät nach Anspruch 4 oder 5, dadurch gekennzeichnet, daß die Spannungspegel-Erkennungsschaltungen (20, 22) bei Überschreiten eines jeweils zugeordneten, auf ein gemeinsames Bezugspotential bezogenen Spannungswertes eine Aktivierung der zugehörigen Anzeige-Ansteuerung (24, 25) auslösen.

7. Prüfgerät nach Anspruch 6, dadurch gekennzeichnet, daß die Eingangs-Pegel, bei welchen die Spannungspegel-Erkennungsschaltungen (20, 22) eine Aktivierung der zugehörigen Anzeige-Ansteuerung (24, 25) auslösen, gleich sind.

8. Prüfgerät nach einem der Ansprüche 4 bis 7, dadurch gekennzeichnet, daß der Eingang (12, 13) der Anzeigeeinrichtung (7) über die Serienschaltung aus einem elektrischen Kondensator (14) und einem Gleichrichter (15) mit dem Spannungsteiler (17, 18) verbunden ist.

9. Prüfgerät nach Anspruch 8, dadurch gekennzeichnet, daß in Serie zwischen dem Gleichrichter (15) und dem Spannungsteiler (17, 18) eine in Sperrichtung liegende Zenerdiode (16) vorgesehen ist, und daß die Verbindungsstelle der Zenerdiode (16) mit dem Fußpunkt (23) des Spannungsteilers (17, 18) an Schaltungsmasse als Bezugs-Potential gelegt ist.

10. Prüfgerät nach Anspruch 9, dadurch gekennzeichnet, daß der Gleichrichter (15) in Brückenschaltung betrieben ist.

11. Prüfgerät nach einem der Ansprüche 1 bis 10, dadurch gekennzeichnet, daß die Anzeigeeinrichtung (7) im Koppelteil (11) integriert ist.

12. Prüfgerät nach Anspruch 11, dadurch gekennzeichnet, daß zum Eingang der Anzeigeeinrichtung (7) eine Steckbuchsenanordnung (8, 9) parallelgeschaltet ist, die frei von außen zugänglich am Koppelteil (11) oder in einem das Koppelteil (11) aufnehmenden Schaltanlagengehäuse montiert ist.

13. Prüfgerät nach einem der Ansprüche 9 bis 12, dadurch gekennzeichnet, daß parallel an die Zenerdiode (16) Stromversorgungsanschlüsse von Steuerelementen, insbesondere der Spannungspegel-Erkennungsschaltungen (20, 22), angeschlossen sind.

14. Prüfgerät nach einem der Ansprüche 5 bis 13, dadurch gekennzeichnet, daß die Anzeigeelemente (26) als LCD-Elemente ausgebildet sind.

15. Prüfgerät nach Anspruch 14, dadurch gekennzeichnet, daß die Anzeigeelemente (26) in einem gemeinsamen LCD-Feld angeordnet sind.

16. Prüfgerät nach Anspruch 14 oder 15, dadurch gekennzeichnet, daß in einem Grundfeld (26.1) ein einen Pfeil darstellendes Pfeilfeld (27) und daneben ein ein Dreieck darstellendes Dreieckfeld (28) mit davon umschlossenem, ein Ausrufezeichen darstellendem Ausrufezeichenfeld (29) ausgebildet sind, daß das Pfeilfeld (27) unansteuerbar ist, daß das Grundfeld (26.1) zusammen mit dem Ausrufezeichenfeld (29) unter Ausschluß des Dreieckfeldes (28) abhängig vom Betriebsstrom-Anzeigesignal und das Dreieckfeld (28) abhängig vom Mindestprüfstrom-Anzeigesignal steuerbar ist.

17. Prüfgerät nach Anspruch 14 oder 15, dadurch gekennzeichnet, daß in einem Grundfeld (26.1) ein einen Pfeil darstellendes Pfeilfeld (27) sowie im Pfeilfeld (27) ein Warnfeld (28') ausgebildet ist, daß das Grundfeld (26.1) unangesteuert ist und daß das Pfeilfeld (27) abhängig vom Betriebsstrom-Anzeigesignal und das Warnfeld (28') abhängig vom Mindestprüfstrom-Anzeigesignal steuerbar ist.

## Claims

1. A testing apparatus for displaying the presence of the rated electrical voltage in high or medium voltage switching installations or apparatuses, comprising an electrode (2) of a coupling portion (11), the electrode being capacitively coupled to a voltage-active electrical component (1) to be monitored, wherein connected to the coupling portion is a display device (7) which, when a predetermined value of an operating current is fed in, produces an operating current display signal, characterised in that the display device (7) has an additional measuring path (22, 25) which, in the event of a value of a minimum testing current to be supplied by the operational coupling portion (11), said value being a predetermined difference value above the predetermined value of the operating current, generates an additional control signal which produces its own minimum testing current display signal.

2. A testing apparatus according to claim 1 characterised in that the operating current display signal and the minimum testing current display signal are linked in such a way that a warning signal is generated when the operating current display signal is present and the minimum testing current display signal is absent.

3. A testing apparatus according to claim 1 or claim 2 characterised in that a testing impedance (30) can be connected in parallel with the single current measuring input (12, 13) of the display device ( 7), said testing impedance being rated for deriving the current having the current difference value.

4. A testing apparatus according to one of claims 1 to 3 characterised in that a voltage divider (17, 18) having tappings (19, 21) is connected to the current measuring input (12, 13) of the display device (7), wherein connected to a first tapping (21) is a voltage level detection circuit (20) for the display signal corresponding to the predetermined operating current value and connected to a second tapping (19) is a voltage level detection circuit (22) for the minimum testing current display signal which is dependent on the minimum testing current value.

5. A testing apparatus according to claim 4 characterised in that the voltage level detection circuits (20, 22) each feed a display control means (24, 25) which when display signals are present respectively activate one or two display elements (26.1, 28, 29).

6. A testing apparatus according to claim 4 or claim 5 characterised in that the voltage level detection circuits (20, 25) trigger activation of the associated display control means (24, 25) when a respectively associated voltage value related to a common reference potential is exceeded.

7. A testing apparatus according to claim 6 characterised in that the input levels at which the voltage level detection circuits (20, 22) trigger activation of the associated display control means (24, 25) are equal.

8. A testing apparatus according to one of claims 4 to 7 characterised in that the input (12, 13) of the display device (7) is connected to the voltage divider (17, 18) by way of the series circuit of an electrical capacitor (14) and a rectifier (15).

9. A testing apparatus according to claim 8 characterised in that provided in series between the rectifier (15) and the voltage divider (17, 18) is a Zener diode (16) connected in the reverse direction, and that the connection of the Zener diode (16) to the base point (23) of the voltage divider (17, 18) is to circuit earth as reference potential.

10. A testing apparatus according to claim 9 characterised in that the rectifier (15) is operated in a bridge circuit.

11. A testing apparatus according to one of claims 1 to 10 characterised in that the display device (7) is integrated in the coupling portion (11).

12. A testing apparatus according to claim 11 characterised in that a plug jack arrangement (8, 9) is connected in parallel with the input of the display device (7) and is mounted freely accessibly from the exterior on the coupling portion (11) or in a switching installation housing accommodating the coupling portion (11).

13. A testing apparatus according to one of claims 9 to 12 characterised in that connected in parallel to the Zener diode (16) are power supply connections of control elements, in particular the voltage level detection circuits (20, 22).

14. A testing apparatus according to one of claims 5 to 13 characterised in that the display elements (26) are in the form of LCD-elements.

15. A testing apparatus according to claim 14 characterised in that the display elements (26) are arranged in a common LCD-panel.

16. A testing apparatus according to claim 14 or claim 15 characterised in that provided in a main panel (26.1) are an arrow panel (27) representing an arrow and therebeside a triangular panel (28) representing a triangle, with a paging character panel (29) which is surrounded by the triangular panel and which represents a paging character, the arrow panel (27) is non-actuable, and the main panel (26.1) together with the paging character panel (29) is controllable, with the exclusion of the triangular panel (28), in dependence on the operating current display signal and the triangular panel (28) is controllable in dependence on the minimum testing current display signal.

17. A testing apparatus according to claim 14 or claim 15 characterised in that provided in a main panel (26.1) is an arrow panel (27) representing an arrow and provided in the arrow panel (27) is a warning panel (28), the main panel (26.1) is non-actuated and the arrow panel (27) is controllable in dependence on the operating current display signal and the warning panel (28) is controllable in dependence on the minimum testing current display signal.

## Revendications

1. Appareil de contrôle pour l'affichage de la présence de la tension électrique nominale dans des installations ou des appareils de distribution électrique à haute ou moyenne tension, comportant une électrode (2), qui est couplée de manière capacitive à un composant électrique (1) à surveiller qui est sous tension, et qui fait partie d'une section de couplage (11) à laquelle est relié un dispositif d'affichage (7) qui, lors de la fourniture d'une valeur prédéterminée d'un courant de service, produit un signal d'affichage de courant de service, caractérisé en ce que le dispositif d'affichage (7) comporte un trajet de mesure supplémentaire (22,25) qui génère, pour une valeur, qui dépasse la valeur prédéterminée du courant de service d'une valeur prédéterminée de différence, d'un courant de contrôle minimal devant être fourni à la section de couplage (11) en fonctionnement, un signal de commande supplémentaire, qui produit un signal d'affichage spécifique de courant de contrôle minimal.

2. Appareil de contrôle selon la revendication 1, caractérisé en ce que le signal d'affichage du courant de service et le signal d'affichage du courant minimal de contrôle sont combinés de telle manière que, lors de la présence du signal d'affichage du courant de service et de l'absence du signal d'affichage du courant minimal de contrôle, on génère un signal d'alarme.

3. Appareil de contrôle selon la revendication 1 ou 2, caractérisé en ce que sur l'entrée unique de courant (12, 13) du dispositif d'affichage (7), on peut brancher en parallèle une impédance (30) qui est dimensionnée pour dériver le courant présentant la valeur prédéterminée de différence.

4. Appareil de contrôle selon l'une quelconque des revendications 1 à 3, caractérisé en ce qu'à l'entrée de courant (12, 13) du dispositif d'affichage (7) est relié un diviseur de tension (17, 18) comportant des prises (19, 21), un circuit de reconnaissance d'un niveau de tension (20) pour le signal d'affichage correspondant à la valeur prédéterminée du courant de service étant branché sur une première prise (21) et un circuit de reconnaissance d'un niveau de tension (22) pour le signal d'affichage du courant minimal de contrôle, qui dépend de la valeur minimale du courant de contrôle, étant branché sur une deuxième prise (19).

5. Appareil de contrôle selon la revendication 4, caractérisé en ce que les circuits de reconnaissance d'un niveau de tension (20, 22) alimentent chacun un dispositif de commande d'affichage (24, 25) qui, lors de la présence de signaux d'affichage, active, à chaque fois, un ou deux éléments d'affichage (26.1, 28, 29).

6. Appareil de contrôle selon la revendication 4 ou 5, caractérisé en ce que les circuits de reconnaissance d'un niveau de tension (20, 22) déclenchent, lors du dépassement d'une valeur de tension associée respective qui est rapportée à un potentiel de référence commun, une activation du dispositif de commande d'affichage (24, 25) associé.

7. Appareil de contrôle selon la revendication 6, caractérisé en ce que les niveaux d'entrée pour lesquels les circuits de reconnaissance d'un niveau de tension (20, 22) déclenchent une activation des dispositifs de commande d'affichage (24, 25) associés, sont égaux.

8. Appareil de contrôle selon l'une quelconque des revendications 4 à 7, caractérisé en ce que l'entrée (12, 13) du dispositif d'affichage (7) est reliée, par l'intermédiaire d'un circuit série comprenant un condensateur électrique (14) et un redresseur (15), au diviseur de tension (17, 18).

9. Appareil de contrôle selon la revendication 8, caractérisé en ce que l'on prévoit, en série entre le redresseur (15) et le diviseur de tension (17, 18), une diode Zener (16) branchée dans le sens du blocage et en ce que la section de liaison de la diode Zener (16) avec le point de base (23) du diviseur de tension (17, 18) est mise à la masse des circuits qui constitue un potentiel de référence.

10. Appareil de contrôle selon la revendication 9, caractérisé en ce que le redresseur (15) est un pont de redresseurs.

11. Appareil de contrôle selon l'une quelconque des revendications 1 à 10, caractérisé en ce que le dispositif d'affichage (7) est intégré dans la section de couplage (11).

12. Appareil de contrôle selon la revendication 11, caractérisé en ce que, sur l'entrée du dispositif d'affichage (7), on branche en parallèle un dispositif de fiches femelles (8, 9) qui est disposé sur la section de couplage (11) en étant librement accessible de l'extérieur ou est monté dans un boîtier de distribution électrique recevant la section de couplage (11).

13. Appareil de contrôle selon l'une quelconque des revendications 9 à 12, caractérisé en ce que, en parallèle sur la diode Zener (16) sont branchées des bornes d'alimentation en courant d'éléments de commande, en particulier des circuits de reconnaissance d'un niveau de tension (20, 22).

14. Appareil de contrôle selon l'une quelconque des revendications 5 à 13, caractérisé en ce que les éléments d'affichage (26) sont constitués par des éléments à cristaux liquides.

15. Appareil de contrôle selon la revendication 14, caractérisé en ce que les éléments d'affichage (26) sont disposés dans une zone commune à cristaux liquides.

16. Appareil de contrôle selon la revendication 14 ou 15, caractérisé en ce que, dans une zone de base (26.1) sont réalisées une zone de flèche (27) représentant une flèche et, à côté, une zone triangulaire (28) représentant un triangle et comprenant une zone de signe d'appel (29) représentant un signe d'appel et entourée par la zone triangulaire, en ce que la zone de flèche (27) ne peut pas être commandée, en ce que la zone de base (26.1) peut être commandée en même temps que la zone de signe d'appel (29), à l'exclusion de la zone triangulaire (28), en fonction du signal d'affichage du courant de service et en ce que la zone triangulaire (28) peut être commandée en fonction du signal d'affichage du courant minimal de contrôle.

17. Appareil de contrôle selon la revendication 14 ou 15, caractérisé en ce que, dans une zone de base (26.1) sont réalisées une zone de flèche (27) représentant une flèche ainsi qu'une zone d'alarme (28') disposée dans la zone de flèche, en ce que la zone de base (26.1) ne peut pas être commandée, en ce que la zone de flèche (27) peut être commandée en fonction du signal d'affichage du courant de service et en ce que la zone d'alarme (28') peut être commandée en fonction du signal d'affichage du courant minimal de contrôle.
